(19) Europäisches Patentamt
European Patent Office
Office européen des brevets

(11) EP 1 528 039 A1

(12) EUROPEAN PATENT APPLICATION

(43) Date of publication:
**04.05.2005 Bulletin 2005/18**

(51) Int Cl.[7]: **B82B 3/00**, B82B 1/00, H01L 49/00, H01L 29/76

(21) Application number: **04025635.6**

(22) Date of filing: **28.10.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **28.10.2003 US 695479**

(71) Applicant: **STMicroelectronics S.r.l.**
**20041 Agrate Brianza (Milano) (IT)**

(72) Inventors:
- **Mascolo, Danilo**
  **80056 Ercolano (Napoli) (IT)**
- **Scaldaferri, Rossana**
  **84073 Sapri (Salcrno) (IT)**
- **Napolitano, Teresa**
  **80030 Cimitile (Napoli) (IT)**
- **Casuscelli, Valeria**
  **80022 Arzano (Napoli) (IT)**
- **Occhipinti, Luigi**
  **95125 Catania (IT)**

(74) Representative: **Ferrari, Barbara**
**Botti & Ferrari S.r.l.,**
**Via Locatelli, 5**
**20124 Milano (IT)**

(54) **Method for manufacturing a single electron device by electro-migration of nanoclusters and corresponding single electron device**

(57) The present invention relates to a method for manufacturing a single electron device (80) by electro-migration of nanoclusters (52). The inventive method comprises the steps of:

- patterning a substrate (10, 40);
- preparing metallic passivated nanoclusters (52);
- forcing the metallic passivated nanoclusters (52) to assembly over the patterned substrate (10) under control of a non homogeneous electric field.

The invention also relates to a single electron device comprising a quantum dot as single electron component.

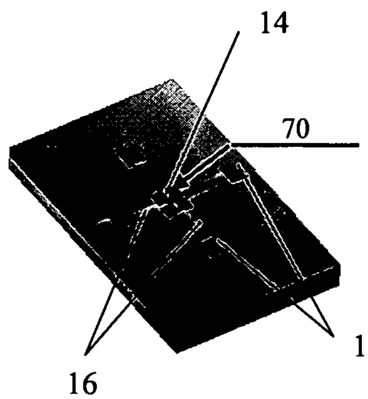

**Figure 5c**

EP 1 528 039 A1

## Description

Technical Field

The present invention relates to a method for manufacturing a single electron device by electro-migration of nanoclusters.

The invention also relates to a single electron device comprising a quantum dot as single electron component housed on a patterned substrate which includes at least an electrode.

To fully understand all the aspects of the present invention reference is made to the enclosed Figures 1-4 showing known examples of single-electron devices.

The enclosed Figure 1 illustrates the basic concept of single-electronics.

Let's first consider a small electroneutral conductor, traditionally called an *island,* having exactly as many ($m$) electrons as protons in its crystal lattice.

In this electroneutral state the island does not generate any appreciable electric field beyond its borders, and a even weak external force $\vec{F}$ may bring in an additional electron from outside. In most single-electron devices, this injection is carried out by a tunneling effect through an energy barrier created by a thin insulating layer. Now, after this injection, the net charge $Q$ of the island would be ($-e$), and the resulting electric field $E$ would repulse any further electron that might be added.

Though the fundamental charge is very small in absolute value ($e \approx 1.6\times10^{-19}$ Coulomb), the electric field $E$ that it generates is inversely proportional to the square of the island size, and may become rather strong for nanoscale structures. For example, the electric field is as large as ~140 kV/cm on the surface of a 10-nm sphere in vacuum.

The theory of single-electron phenomena shows that a more adequate measure of the strength of these effects is not the electric field, but the *charging energy:*

$$E_c = e^2/C \qquad (1)$$

where $C$ is the capacitance of the island. When the island size becomes comparable with the de Broglie wavelength of the electrons inside the island, their energy quantization becomes substantial. See for instance the articles by: M. A. Kastner, "Artificial Atoms", *Physics Today,* vol. 46, pp. 24-31, January 1993; or U. Meirav and E.B. Foxman, "Single-electron phenomena in semiconductors", *Semicond Sci. Technol.* vol. 10, pp. 255-284, October 1995.

In this case the energy scale of the charging effects is given by a more general notion, the *electron addition energy* $E_a$. In most cases of interest, $E_a$ may be well approximated by the following simple formula:

$$E_a = E_c + E_k \qquad (2)$$

Wherein $E_c$ is given by equation (1) and $E_k$ is the quantum energy of the added electron; for a degenerate electron gas the quantum energy is:

$$E_k = 1/g(E_F)V \qquad (3)$$

where $V$ is the island volume and $g(E_F)$ is the density of states on the Fermi surface.

Figure 2 shows the total electron addition energy as a function of the island diameter, as calculated using Eq. (2) for a simple but representative model.

For 100-nm-scale devices which were typical for the initial stages of experimental single-electronics, $E_a$ is dominated by the charging energy $E_c$ and is of the order of 1 meV, i.e. ~ 10 K in temperature units.

Since thermal fluctuations suppress most single-electron effects unless $E_a \geq 10k_BT$, these experiments have to be carried out in the sub-1-K range (typically, using helium dilution refrigerators). On the other hand, if the island size is reduced below ~10 nm, $E_a$ approaches 100 meV, and some single-electron effects become visible at room temperature.

However, most suggested digital single-electron devices require even higher values of $E_a$ ($\approx 100k_BT$) in order to avoid thermally-induced random tunneling events, so that for room temperature operation the electron addition energy $E_a$ has to be as large as a few electron-volts, and the minimum feature size of single-electron devices has to be smaller than ~1 nm, as shown in the diagram of Figure 2.

In this Figure 2 a single-electron addition energy Ea is shown as a solid line, while the charging energy Ec is shown as dashed line and the electron kinetic energy $E_k$ as dotted line, all calculated using Eqs. (1) and (2) for a simple

model of a conducting island. In such a model the island is a round 3D ball with a free, degenerate electron gas, embedded into a dielectric matrix (dielectric constant e = 4), with 10% of its surface area occupied by tunnel junctions with a barrier thickness d = 2 nm. Reference is made to K.K. Likharev, Proc. IEEE, vol. 87, pp. 606-632, April 1999.

In this size range the electron quantization energy $E_k$ becomes comparable with or larger than the charging energy $E_c$ for most materials; this is why islands of these small sizes are frequently called *quantum dots.* Their use involves not only extremely difficult nanofabrication technology (especially challenging for large scale integration), but also some major physics problems including the high sensitivity of transport properties to small variations of the quantum dot size and shape. This is why it is very important to develop single-electron devices capable of operating with the lowest possible ratio $E_a / k_B T$.

Some examples of single electron devices have been studied and are reported in literature. The following paragraphs will briefly summarize a couple of these devices as state-of-the art technologies for SET, while the article by K.K. Likharev reports the basic theoretical background and physical principles governing the SET functioning.

Background Art

The simplest device that shows single electron phenomena is the *"single-electron box"* like that shown in Figure 3a, and reported by K.K. Likharev. This device comprises just one small island separated from a larger electrode *("electron source")* by a tunnel barrier. An external electric field may be applied to the island using another electrode ("*gate*") separated from the island by a thicker insulator, which does not allow noticeable tunneling. The field changes the electrochemical potential of the island and thus determines the conditions of electron tunneling.

This device allows to verify experimentally the phenomenon, known as *"Coulomb staircase",* which is gradually smeared out by thermal fluctuations if the temperature is increased to $k_B T \approx E_c$.

Coulomb staircase is a very simple physic phenomenon: increasing gate voltage U attracts more and more electrons to the island. The discreteness of electron transfer through low transparency barriers necessarily makes this increase step-like. Then even such a simple device allows a reliable addition/subtraction of single electrons to/from an island with an enormous (and unknown) number of background electrons, of the order of 1 million in typical low-temperature experiments with 100-nm-scale aluminum islands.

This is of course simply a consequence of the enormous strength of the unscreened Coulomb interaction occurring at low temperatures and, in fact, is the main limitation for the physical implementation of such a kind of single electron devices that are fabricated by scaling down the feature sizes from conventional microelectronics technologies.

Splitting the tunnel junction of the single electron box and applying a dc voltage $V$ between the two, now separated, parts of the external electrode allows obtaining the structure of Figure 4a. The resulting *"single-electron transistor* (*SET*)" is probably the most important device in this technical field. In fact, there have been several studies and experimental analysis carried out on this device by some major research organizations in the physics and nanotechnology field.

The expression for the electrostatic energy W of the system is:

$$W = (ne - Q_e)^2 / 2C_\Sigma - eV[n_1 C_1 + n_2 C_2] + const \qquad (4)$$

Here $n_1$ and $n_2$ are the number of electrons passed through the tunnel barriers 1 and 2, respectively, so that $n = n_1 - n_2$, while the total island capacitance $C_\Sigma$ is now a sum of $C_0$, $C_1$, $C_2$, and whatever stray capacitance the island may have. The external charge $Q_e$ is defined by the equation

$$Q_e = UC_0 \qquad (5)$$

and is just a convenient way to present the effect of the gate voltage U.

Figures 4a to 4c relates to capacitive-coupled single-electron transistor, and in particular show: (a) schema, (b) source-drain dc I-V curves of a symmetric transistor for several values of the Qe, i.e. of the gate voltage, and (c) the Coulomb blockade threshold voltage $V_t$ as a function of $Q_e$ at $T \rightarrow 0$.

Figure 4b shows typical dc $I - V$ curves of this system. At small source-drain voltage $V_t$ there is no current, since any tunneling event would lead to an increase of the total energy ($\Delta W < 0$) and hence at low enough temperatures ($k_B T << E_c$) the tunneling rate is exponentially low. This suppression of dc current at low voltages is known as the *Coulomb blockade.* At a certain *threshold voltage* $V_t$ the Coulomb blockade is overcome, and at much higher voltages the dc $I - V$ curve gradually approaches one of the offset linear asymptotes:

$$I \rightarrow (V + sign(V) \cdot (e/2C_{\Sigma}))/(R_1 + R_2)$$

On its way, the *I-V* curve exhibits quasi-periodic oscillations of its slope, closely related in nature to the Coulomb staircase in the single-electron box, and expressed especially strongly in the case of a strong difference between $R_1$ and $R_2$.

The most important property of the single-electron transistor is that the threshold voltage, as well as the source-drain current in its vicinity, is a periodic function of the gate voltage. This periodicity is evident from Eqs. (4) and (5): if U is changed by $\Delta U = e/C_0$ , $Q_e$ changes by e, and may be exactly compensated for by one of the electrons tunneling into or from the island.

As the transistor island becomes smaller, the effects of energy quantization may become important. The theory shows that its dc *I-V* curves may be quite complex, as disclosed by D.V. Averin, A.N. Korotkov, and K.K. Likharev, "Theory of single-electron charging of quantum wells and dots", *Phys. Rev. B,* vol. 44, pp. 6199-6211, September 1991.

However, the situation at small source-drain voltage is much simpler. In fact, Fig. 4c shows that on each period of the Coulomb blockade oscillations there is one special point:

$$Q_e = e(n + 1/2)$$

at which the Coulomb blockade is completely suppressed, and the *I-V* curve has a finite slope at low voltages (see Fig. 4b).

Another way to express the same property is to say that the linear conductance $G = dI/dV|_{v=0}$ of the transistor as a function of the gate U voltage exhibits sharp peaks. Theory shows that even if the electron quantization effects are substantial, the peak position may be found from a very natural "resonance tunneling" condition as disclosed by H. van Houten, C.W.J. Beenakker, and A.A.A. Staring, "Coulomb blockade oscillations in semiconductor nanostructures", in: *Single Charge Tunneling,* ed. by H. Grabert and M.H. Devoret. New York: Plenum, 1992, pp. 167-216; and by C.W.J. Beenakker, "Theory of Coulomb-blockade oscillations in the conductance of a quantum dot", *Phys. Rev. B,* vol. 44, pp. 1646-1656, July 1991.

So, an energy level inside the island (with the account of the gate field potential) should be aligned with the Fermi levels in source and drain, which coincide at $V \rightarrow 0$. This rule yields a simple equation for the gate voltage distance between the neighboring Coulomb blockade peaks:

$$\Delta U = (C_{\Sigma}/C_0)E_a/e \qquad (6)$$

Fabrication of SET involves many difficulties for this device to be used in a large scale industrial production, since:

- It is vitally important to develop technologies to realize nanoscale Quantum Dots (QD) and quantum wires, which are coupled together through tunneling barrier, and which must be precisely controlled in their size and position.
- Process induced damages and contamination must be avoided in the fabrication of large scale SET circuits.
- The technique must have high reproducibility and controllability.

Basically the fabrication methods can be divided as physical or chemical techniques according to the main procedures.

The physical methods often utilize the combination of thin film and lithographic technologies.

Devices with carefully tailored geometries and electron density are obtained. For example, quantum dots or quasi-zero-dimensional puddles of electrons with weak coupling to simultaneously patterned electrical leads are fabricated to form a SET. However, lithographic and materials limitations restrict the minimum size and composition of such dots (100nm), and studies are typically limited to sub-Kelvin temperatures.

Another possible approach is to grow nanostructures chemically as reported by David L. Klein, Paul L. McEuen, etc., in Appl. Phys. Lett., vol. 68, 1996, p. 2575.

This approach is prosperous for its low cost and good controllability of the size of Coulomb islands, and it is possible to be a prospective technique.

Though this technique is not mature industrially, the SETs fabricated in laboratories show fascinating results.

Generally there are three most important steps:

- first, the fabrication of Coulomb islands as well as the control of their size and dispersity;
- second, the formation of tunneling junctions at the joint of electrodes and Coulomb island;
- third, the formation of gate between substrate and Coulomb islands.

The aim of the present invention is that of providing a new and original solution for the manufacturing of single electron device, preferably, but not necessarily, working at room temperatures.

## Summary of the invention

The solution idea behind the present invention is that of developing single electron (SE) devices working preferably, but not necessarily, at room temperature using a new technology process and building up a set of nanocontacts that can be self-assembled and able to maintain a desired separation distance, particularly in the ~10 nm range, including as well a quantum dot made up of a single nanoparticle, which can be sized in the same range.

More specifically, based on this solution idea a patterned substrate over which nanoclusters are forced to assembly under the control of a not homogeneous electric field is employed. The substrate may be patterned by a lithographic technique or by other techniques such as SAM (Self Assembled Monolayers); MicroPrinting or DNA-Scaffolding. Moreover, the substrate could be a polimeric substrate; glass or ITO; that is: a non silicon substrate.

Based on this solution idea, the technical problem is solved by a method for manufacturing a single electron (SE) device by electro-migration of nanocluster as claimed in claim 1.

The technical problem is also solved by a single electron device, as claimed in claim 27.

The features and advantages of a manufacturing method and device according to the invention will be apparent from the following description of an embodiment thereof, given by way of non-limitative example with reference to the accompanying drawings.

## Brief description of the drawings

**Figure 1** shows the basic concept of single-electron control: a conducting island (a) before and (b) after the addition of a single electron.

**Figure 2** shows the behavior of the single-electron addition energy Ea (solid line), charging energy Ec (dashed line) and electron kinetic energy $E_k$ (dotted line) according to the 3D ball island model;

Figure 3 shows a single-electron box: (a) schema, (b) particular geometry, (c) step-like dependence of the average charge Q = -ne on the gate voltage, for several values of temperature;

Figure 4 shows a known capacitive-coupled single-electron transistor: (a) schema, (b) source-drain dc I-V curves of a symmetric transistor for several values of the Qe, i.e. of the gate voltage, and (c) the Coulomb blockade threshold voltage $V_t$ as a function of $Q_e$ at $T \rightarrow 0$;

**Figures 5A, 5B, 5C** schematically show process steps for realizing a patterned semiconductor substrate of the method according to the invention;

**Figure 6** is a schematic view of an example of nanoclusters passivation step of the method according to the invention;

**Figure 7** is a schematic diagram showing the Real part and Imaginary part of $f_{CM}$ as function of frequency;

**Figure 8** is a schematic diagram showing the Real part and Imaginary part of $f_{CM}$ in function of frequency and conductivity;

**Figure 9** shows a schema of the electrodes for Dielectrophoresis to be used in the method according to the invention;

**Figures 10A, 10B, 10C** show different steps of the method according to the invention for obtaining a nanocontact;

**Figures 11A and 11B** show different steps of the method according to the invention for obtaining a nanowire;

**Figures 12-18** show different steps of the method according to the invention for obtaining a single electron (SE) device.

Detailed description

The present invention realizes a single-electron or SE device working at room temperature by employing a lithographic patterned substrate over which nanoclusters are forced to assembly under the control of a not homogeneous electric field. The controlled migration and the desired location of the metallic passivated nanoclusters are based on the a dielectrophoretic process, which is well-known by itself but has never been applied in this field.

In particular, advantageously according to the invention, a method for realizing a SE device is provided.

The method comprises, as a first phase, the realization of a patterned substrate.

In particular, on a semiconductor substrate 10, for instance a silicon substrate with a silicon oxide layer 12 formed thereon, a central aperture 14 and paths 16 for metallic contacts and peripheral apertures 18 are opened, leaving a thickness of the oxide layer 12 over the Si substrate 10.

More particularly, in a preferred embodiment, the central aperture 14 is rectangular and has a depth of about three times its width. A high conductive metallic layer 20, for instance a gold layer, is deposited on the contact paths 16 and in the peripherals apertures 18 to form contact pads 22 without invading the central aperture 14.

Then an oxide layer 24 is deposited on the contact links between the central aperture 14 and the pads 22. Thus, the pads 22 have free-contact surfaces, four in this example, are available as electrodes for the dielectrophoresis control.

The described patterned process steps are schematically shown in Figures 5A, 5B, 5C and 12.

According to the invention, the method comprises, as a second phase, the deposition of nanoclusters by means of a dielectrophoresis process.

In particular, as it will be clear from the following description, by this deposition phase it will be possible to deposit metal nanowires on whatever substrate at relatively low temperature and with low cost. Advantageously according to the present invention, the deposition phase exploits metallic nanoclusters as building blocks to growth up nanowires, under the control of an external electric field.

On the contrary, the technologies in use for nanowires production employ expensive and sophisticated process.

In particular, the main well-known competing methods to fabricate nanowires in general can be grouped in the following categories:

- lithography;
- deposition into tracks of high-energy particles polymer;
- deposition of onto step-edge and STM manipulation;

In the latest years others techniques have been developed for nanowires realization. In particular:

- filling nanotubes with metal atoms, as disclosed by Braun et al., in Nature 391, 775, (1998);
- loading DNA with silver and selective electro-deposition onto MBE-grown template, as disclosed by G. Fasol, K. Runge, Appl. Phys. Lett. 70, 2467, (1997).

Also these recent techniques have main drawbacks. The first method has a great disadvantage due to the fact that metal reacts chemically with carbon tube walls and the research of remedies is in running.

In the second method instead, only some kind of metals can be processed to fabricate nanowires.

Another possible way employs the electrical properties of some carbon nanotubes like 'armchair' SWNT but nowadays lots of difficulties are connected to the controlled synthesis of this kind of carbon structures and the research in this field is in running at present.

In order to overcome the disadvantages of the above outlined known technologies, a method for manufacturing a single electron device by electro-migration of nanoclusters is proposed. As it will be clear in the following description, the method comprises the steps of:

- patterning a substrate;
- preparing metallic passivated nanoclusters; and
- forcing the metallic passivated nanoclusters to assembly over said patterned substrate under control of a non homogeneous electric field.

So, the inventive process comprises a deposition phase which in turn includes the following steps:

1. Synthesis of metallic nanoclusters surrounded by a dielectric shell of thioles of controlled size;
2. Deposition of the nanoclusters by dielectrophoresis;
3. Sintering of the nanoclusters in a nanowire after desorbation of the bonded dielectric shell as result of heating.

In particular, the step of synthesis of metallic nanoclusters in turn comprises the steps of:

*a) Synthesis of active metal*

*b) Superficial passivation with thiol*

*c) Extraction and purification*

As for the synthesis of active metal step, a polyol process is used to prepare finely divided powders of easily reducible metals.
In this polyol process a suitable solid inorganic compound, in particular a starting metal compound, is suspended in liquid polyol. The suspension is stirred and heated to a given temperature that can reach the boiling point of the polyol for the less easily reducible metals.
The reduction of the starting metal compound quantitatively yields the metal as a finely divided powder. This starting compound may be a hydroxide, an oxide, and a convenient salt. The reduction to metal can be achieved employing various polyols, ethylene glycol (EG), and diethylene glycol (DEG) being the mainly used. The reduction reaction proceeds in polyvinylpyrrolidone (PVP, Aldrich $M_w$ 10000) that acts as reducing agent and inhibitor of the aggregation process of the nanoclusters so formed.
In particular, the synthesis of active metal step proceeds according to a reaction mechanism comprising two stages that are described as follows:

*$1^{st}$ stage Crystallized hydroxide → intermediate phase*

- Progressive dissolution in a polyol of a starting metal compound, said metal compound being a metal hydroxide, metal oxide or metal salt, in order to form a solution;
- Precipitation of an intermediate phase from the solution;
- Evolution of water by distillation.

*$2^{nd}$ stage Intermediate phase → metal*

- Dissolution in a polyol of the intermediate phase to form a solution;
- Reduction in solution of the intermediate phase;
- Evolution of volatile reaction products of the reduction from the solution;
- Spontaneous nucleation and growth of metal particles from the solution.

The main feature of this reaction mechanism is that the reduction reaction proceeds via the solution rather than in the solid state. Therefore, the metal particles are formed by nucleation and growth from the solution. This main feature is quite general for all investigated reactions and for all metals obtained by this polyol process.

According to this reaction mechanism, the polyol acts first as a solvent for the starting inorganic or metal compound. The occurrence in the above described reaction of an intermediate solid phase between the starting material and the final metal powder is not quite general but is very frequently observed.

During the second stage of the reaction mechanism the second dissolution of the intermediate solid phase takes place and the reduction of the metal Me occurs in the liquid phase, i.e. in solution.

The whole reduction reaction can be so formulated:

$$2\ CH_2OH\text{-}CH_2OH \rightarrow 2\ CH_3CHO + 2\ H_2O$$

$$2\ CH_3CHO \xrightarrow[Me+]{} CH_3\text{-}CO\text{-}CO\text{-}\ CH_3 + H_2O + Me$$

The metal Me is generated in the liquid phase and when the supersaturation of such solution is high enough, nucleation and growth occur. The metal particles or metallic nanoclusters so formed are isotropic; the homogeneous nucleation model explaining these characteristics with an effective separation between the nucleation and growth steps.

The grow parameters of the above described chemical synthesis of active metal allow to control the size of metallic cores while, as will be explained hereunder, the kind of thiol, and in particular the number n of the groups ($CH_2$) defines the thickness of the shell and therefore the size of the conductive barrier and the linear resolution of the process.

The reaction temperature influences the morphological characteristics of the metal particles. As a general rule a decrease of the mean size of the metal particles is observed as the reaction temperature increase.

As for the superficial passivation with thiol step, the metallic nanoclusters are stabilized by superficial treatment via thiol.

In particular, the metallic suspension obtained after the nucleation and growth of the metal particles is cooled and treated at room temperature with a dodecanthiol ($CH_3(CH_2)_{11}SH$) solution or with a thiol excess having the following formula: $CH_3(CH_2)_nSH$, where n is an integer.

In particular, a concentrated solution is prepared by adding PVP to the metallic suspension and, then, thiol molecules are chemically absorbed to the nanoclusters surface following the reaction:

$$Me_n + m\ R\text{-}SH \rightarrow Me_n(SR)_m + m/2\ H_2$$

As for the extraction and purification step, the metallic nanoclusters are separated by extraction with hydrocarbon (wet-way process) or by addition of water followed by filtration (dry-way process). Hexane is mainly used as hydrocarbon for wet-way process.

The metallic nanoclusters are purified by dissolution in ethyl alcohol and precipitation with acetone. The precipitation product is separated by centrifugation and made dry to the air.

Advantageously, the method of the invention then follows with a phase of nanoclusters deposition by dielectrophoresis.

As it is well kwon, the process of dielectrophoresis (DEP) is defined as the motion of neutral, polarizable matter produced by a non-uniform electric (AC or DC) field, see for instance the work of H. A. Pohl, "Dielectrophoresis", Cambridge University Press, Cambridge, 1978.

It must be noted that the dielectrophoresis process is fully distinguished from the electrophoresis process, which is the motion of charged particles in a uniform electric field.

The principle of DEP lies in the fact that a net force can arise upon even neutral particles situated in a non-uniform electric field. In particular, when a particle suspended in a medium becomes electrically polarized as result of the interaction with an external electric field, a force acts on the particle. This force can be thought as rising from a two step process comprising a first step of induction or alignment of an electric dipole included in the particles followed by a second step of application of unequal forces of the end of that dipole. Since the two equally charged ends of the dipole lie in unequal field strengths of the diverging field, a net force arises.

The DEP-induced particle motion is strongly dependent on the field frequency, the spatial configuration of the electrodes responsible of field generation, the dielectric properties of the suspended medium and of the particle itself.

A small neutral particle at equilibrium in a static electric field experiences a net force which is represented by the following equation:

$$\vec{F}_{DEP} = (\vec{p} \cdot \vec{\nabla})\vec{E} \qquad (7)$$

where $\vec{p}$ is the dipole moment and $\vec{E}$ is the external electric field.

If the particle is a dielectric which is isotropically, linearly and homogenously polarizable, than

$$\vec{p} = \alpha \nu \vec{E} \qquad (8)$$

where $\alpha$ is the polarizability and $\nu$ is the particle volume. Then the force can be rewritten as:

$$\vec{F}_{DEP} = \alpha\nu(\vec{E} \cdot \vec{\nabla})\vec{E} = \frac{1}{2}\alpha\nu\vec{\nabla}|\vec{E}|^2 \qquad (9)$$

So, this force equation can now be used to find force in model system such as that of a dielectric sphere (relative complex permittivity

$$\varepsilon_p^* = \varepsilon_p - j\left(\frac{\sigma_p}{\omega}\right))$$

in an insulating dielectric fluid (relative complex permittivity

$$\varepsilon_m^* = \varepsilon_m - j\left(\frac{\sigma_m}{\omega}\right))$$

and equation (9) becomes:

$$\vec{F}_{DEP} = 2\pi a^3 \varepsilon_m \left( \mathrm{Re}(f_{CM})\vec{\nabla}\left|\vec{E}\right|^2 + \mathrm{Im}(f_{CM})\left(E_x^2\vec{\nabla}\varphi_x + E_y^2\vec{\nabla}\varphi_x + E_z^2\vec{\nabla}\varphi_z\right)\right) \qquad (10)$$

where $f_{CM} = \frac{\varepsilon_p^* - \varepsilon_m^*}{\varepsilon_p^* + 2\varepsilon_m^*}$ is the Clausius-Mosotti factor, $\alpha$ is the particle radius and $\varphi$ is the electric field phase. So if the particle is more conductive than the medium around it, the dipole aligns with the field and the force acts up the field gradient towards the region of highest electric field.

On the contrary if the particle is less polarizable than the medium, the dipole aligns against the field and particle is repelled from the regions of high electric field. So the force is unaffected by the direction of the electric field, responding only to the field gradient. Since the alignment of the field is irrelevant one could generate the electric field in AC, with the advantage of reducing any electrophoretic force, due to any net particle charge, to zero.

It's worth noting that magnitude of $\vec{F}_{DEP}$ depends on the frequency of the AC electric field, since real and imaginary part of $f_{CM}$ are very different according to the work frequency (as can be shown in Figure 8). It's useful to set the working frequency so as to choose the weight of each of the two contributes of the force, linked to the real or the imaginary part.

So, as result, the real component of $f_{CM}$ is usually used to trap the particle, while the imaginary component is for translational particle actuation. The field induced force increases as field gradient becomes stronger. An increase of field gradient can be obtained by miniaturization of the electrodes.

To develop a model in order to control the migration process, in the balance of applied forces it must be considered also the Stokes friction force due to the viscosity of the host fluid as result of the motion of a sphere in it:

$$\vec{W}_R = -6\pi\eta\alpha\vec{v}$$

where η is the viscosity of medium.

A schematic view of a polarizable particle suspended within a point-plane electrode system is shown in Figure 9. The system 30 includes a plane electrode 32 and a point electrode 34 with a particle 36 between the electrodes. When the particle 36 polarizes, the interaction between the dipolar charges with the local electric field produces a force.

Due to the inhomogeneous nature of the electric field, the force is greater in the side facing the point electrode 34 than that on the side facing the plane electrode 32, and there is net motion of the particle 36 towards the point electrode 34. This effect is called positive dielectrophoresis. If the particle 36 is less polarizable than the surrounding medium, the dipole of the particle 36 will align in opposition with respect to the electric field and the particle 36 will be repelled from the high field regions. This effect is called negative dielectrophoresis.

Then, the method according to the invention further comprises a phase of realization of a nanocontact.

In fact, before the nanowire synthesis phase, it is necessary to realize a nanocontact, whose target offers a reference point for the growth of the nanowire as well the electrode towards which the nanoclusters move under the control of the electric field, as shown in figures 10A to 10C. The nanocontact realization phase comprises in turn:

- a substrate 40 is processed to be patterned, for instance by lithography, to obtain a metallic layer 42 between two oxide layers 44, 46 with a free face 48 available for electro-deposition;

- when an electric field is applied between a flat panel 50 and the metallic free face 48, a passivated nanocluster 52, whose sizes are comparable to the thickness of the metallic layer 42, moves to the free face 48, under dielectrophoresis, with the thioles S-H group linked to it;

- the substrate 40 is then heated by a heater 54 until the thioles degradation temperature is reached; when this occurs the dielectric shell realized by the thioles, surrounding the metal core of the nanocluster 52, vanishes leaving a nanoparticle or nanocontact 56 that finds stability joining the free face 48.

The thioles degradation may be performed even by UV treatment.

However, the process may even not require a treatment for thioles degradation since in case of very thin thioles barriers (about nm) the tunneling effect could assure a significant conduction.

The so-created nanocontact 56 is the new reference point for the others nanoclusters 52 since the force lines of the electric field get denser close to a smaller radius curvature region such as the nanocontact itself, as shown in figures 11 A and 11 B.

In this new configuration others smaller nanoclusters 52 join together as an one-dimensional array; then a new heating produces the degradation of the thioles shells and a nanowire 58 is formed.

In other words, under control of a non homogeneous electric field the metallic passivated nanoclusters are forced to assembly.

It must be noted that, according to the present invention, metallic nanoclusters could be deposited for catalytic applications, in such a way to realize catalytic material by a dielectric deposition. A possible application for these kind of metallic nanoclusters is the growing of nano-tubes or the use as catalytic loads in polimeric electrodes.

Starting from the above method for realizing a nanowire, a method for producing a SE device is also described, with reference to figures 12 and 13.

Advantageously according to the present invention, the method for producing a SE device, comprises a first step of patterning of a substrate, as already described above with reference to figures 5A-5C.

After having dipped the patterned substrate in a solution containing metallic passivated nanoclusters, a flat electrode 60 is suspended parallel to the patterned substrate without contacting it, as can be seen in Figure 12. Also shown in figure 13 is an enlarged view of a central aperture 14 of the patterned substrate, wherein North, East, South and West electrodes (respectively indicated as 62, 64, 66 and 68) formed in the paths 16 are highlighted.

In the preferred embodiment shown in Figure 13, the central aperture 14 is rectangular and the electrodes 62, 64, 66, 68 are substantially central located with respect to the central aperture sides.

The distance between the electrode 60 and the patterned substrate is one of the design parameters which allows to control the curvature of the force lines of the electric field and so the dielectrophoresis force as well as the potential applied to it. In details, a potential difference is applied between the four electrodes 62, 64, 66 and 68, held to the same potential and the plate-electrode 60: the configuration of the electrodes 62, 64, 66 and 68 is chosen so as to let the absolute root value of the electric field have its maximum next to the free face of the four electrodes 62, 64, 66 and 68 facing the central aperture 14.

In this way metallic nanoclusters are obliged to migrate towards the free faces of the four electrodes 62, 64, 66 and 68 and to self-assembly in a direction perpendicular to those faces. Then nanowires 70 are generated and represent a powerful matter to link the nanometric world of the quantum dot to the macroscopic easily managed world of the patterned electrodes.

Advantageously, according to the present invention, the metallic passivated nanoclusters 52 are forced to assembly under control of a non homogeneous electric field, said process step being performed at room temperature.

So, using the patterned substrate shown in figure 13 and applying an electric field by means of the plate electrode 60, a first and a second nanowires, aligned with the perpendicular directions N-S and W-E defined by the four electrodes 62, 64, 66 and 68, are obtained.

However, the ability to control precisely the process of self-assembly nanoclusters is depending on the uniformity of the electric field between the top electrode 60, acting as flat panel, and the four electrodes 62, 64, 66 and 68 where the nanoclusters are self-assembled.

So, advantageously according to the invention, before the dielectrophoresis process, an integrated microcavity is realized in order to guarantee the possibility to act a fine control of the distance $d_z$ between the top electrode 60 and the patterned substrate as well as the control of its shape, and so in order to precisely control the nanowire assembly.

A typical example of process flow-chart to build up the integrate microcavity 82 as well as an integrated top electrode 60 is reported in the scheme sequence of Figures 14-18, which is only intended as a possible realization scheme not exhaustive of the possible alternative realizations.

The process of Figures 14-18 begins similarly to the process of Figures 5A-5C with the formation of a thin silicon oxide layer ($SiO_2$) 12 on a silicon (Si) substrate 10 as shown in Figure 14. Then, instead of etching a central aperture 14 and contact pads 16 in the silicon oxide layer 12, as in Figures 5A-5C, advantageously according to the invention, the process comprises a step of depositing aluminum or other metal contacts 72 on the silicon oxide layer 12, in such a way to form a central aperture 74 (which correspond to the central aperture 14 of Figure 13) between the metal contacts 72, as shown in Figure 15.

The process further comprises a step of forming a silicon nitride sacrifical layer 76 in such a way to fill the central aperture 74 and to cover at least portions of the metal contact 72, as shown in Figure 16.

The thin silicon oxide layer 12 is then grown to form a thick silicon oxide layer 78 laterally of the silicon nitride sacrifical layer 76 and on the metal contacts 72, as shown in Figure 17.

The process still further comprises a step of removing the silicon nitride sacrifical layer 76 so forming the integrated microcavity 82.

Then , the process comprises a step of forming a plate electrode 60 on the thick silicon oxide layer 78 and above the central aperture 74, so closing the microcavity 82, as shown in Figure 18.

Finally, the process comprises a phase of forming nanowires 70 within the integrated microcavity 82 according to the dielectrophoretic process described above with reference of Figures 12 and 13, so obtaining a complete single electron (SE) structure 80.

It should be noted that, advantageously, the central aperture 14 in the patterned substrate is chosen rectangular in order to have, for example, a distance between the N-S electrodes 62, 66 bigger than distance between the E-W electrodes, 64, 68. In this way, a couple of nanowires 70 of different lengths are obtained, as shown in Figure 13. In particular, the WE electrodes distance is chosen of the order of 10nm.

A typical size for the central aperture 14 of the microcavity is $90x150nm^2$ (that can be obtained for instance by conventional lithography techniques) and 30nm for electrodes width so that, if the nanowires 70 are developed with a final length of about 40nm, it will results in a W-E electrodes distance of about 10nm and a N-S electrodes distance of about 70nm.

Advantageously according to the invention, the gap between the so obtained nanowires 70 starting from the electrodes 62, 64, 66, 68 defines a location for a metallic passivated nanocluster acting as quantum dot. In this way, after nanowires fabrication, the maximum value of the electric field absolute root applied by the plate electrode 60 lets a nanocluster occupy such a nanowires gap, so obtaining a complete SE structure 80, as shown in figure 18.

This structure 80 including four terminal electrodes (62, 64, 66, 68) may be used, for example, as an AND/OR logic gate.

Analogously, the process can easy be extended to integrate more than one Single Electron (SE) Devices in a single microcavity as well as to integrate both SE devices with conventional components and circuits (for example to integrate the signal amplifiers and conditioning circuits, as well as to develop a buried resistor grid which will act as the heater for the thioles degradation in the final steps of the nanowires realization).

So, as shown in figures 5A-5C and 18, the invention also relates to a single electron device comprising a quantum dot as single electron component housed on a patterned substrate 10 or 40 which includes at least an electrode connected by at least a nanowire 70 to the quantum dot.

In particular, the single electron device, shown in the figures as a preferred embodiment of the present invention, comprises a plurality of electrodes 62, 64, 66, 68 connected by a plurality of nanowires 70 to the quantum dot, the gap between the nanowires 70 defining a location for the quantum dot, as explained above.

Advantageously, the quantum dot is realized by a metallic passivated nanocluster 52, according to the present invention.

Also, the single electron device according to the present invention includes a microcavity 82 having a central aperture 14, 74 surrounded by the electrodes 62, 64, 66, 68 and housing the nanowires 70 as well as the quantum dot.

All these possibilities are intended as an extension of the basic idea, suitable to develop a hybrid nanotechnology and nanofabrication approach to develop novel SE-based circuits working at room temperature.

It is worth noting that from the basic four-electrodes patterned substrate it is possible to build up SE devices of different kind depending on the material used to realize either the four nanowires or the quantum dot.

Then possible choices involve the employment of metallic CNT or any organic conductive material (polythiophene based-molecules) as nanowires, while as quantum dot one could use either a metallic or semiconductive material according to the desired properties and applications. Another possible choice, for the quantum dot, involves the use of treated carbon structures ($C_{60}$ based molecules) or Si clusters surrounded by a $SiO_2$ dielectric shell.

The method of the present invention does solve the technical problem and achieves various advantages and benefits.

An important benefit of this process is the possibility to realize controllable length and width nanowires overcoming the limits of the prior art techniques. The invention also allows the development of new family of nanoelectronic devices easily and cheaply.

Employing this technique one can build up basic single-electron devices (SE-box, SE-transistor, SE Turnstile and pump, SE transistor oscillators), analog application (supersensitive electrometry, SE spectroscopy, CD current standards, temperature standards, resistance standards, detection of infrared radiation) and digital application (voltage state logics, charge state logics, SET/FET memory, NOVAROM).

The proposed structure can be used either as a SET device, driving both the gate electrodes with the same control signal, or as a logic gate, driving each gate electrode with a suitable digital signal. In particular the latter can be used either as an OR or as an AND gate, depending on the signal value applied at each gate electrode.

From the foregoing it will be appreciated that, although specific embodiments of the invention have been described herein for purposes of illustration, various modifications may be made without departing from the scope of the invention as defined in the annexed claims.

## Claims

1. Method for manufacturing a single electron device (80) by electro-migration of nanoclusters (52) **characterized in that** it comprises the steps of:

   - patterning a substrate (10, 40);
   - preparing metallic passivated nanoclusters (52);
   - forcing said metallic passivated nanoclusters (52) to assembly over said patterned substrate (10) under control of a non homogeneous electric field.

2. Method according to claim 1 **characterized in that** said step of forcing said metallic passivated nanoclusters (52) comprises a dielectrophoretic process.

3. Method according to claim 1 **characterized in that** said step of forcing said metallic passivated nanoclusters (52) is performed at room temperature.

4. Method according to claim 1 **characterized in that** said step of preparing metallic passivated nanoclusters (52) includes the following steps:

   - synthesis of active metal;
   - superficial passivation of said active metal with thiol;
   - extraction and purification of said metallic nanoclusters (52).

5. Method according to claim 4 **characterized in that** said step of synthesis of active metal comprises a polyol process used to prepare finely divided powders of easily reducible metals.

6. Method according to claim 5 **characterized in that** said polyol process comprises a reaction mechanism in two

stages as follows:

*1st stage*

- dissolving a starting metal compound in a polyol in order to form a first solution;
- precipitating an intermediate phase from said first solution;
- removing water by distillation from said intermediate phase.

*2nd stage*

- dissolving said intermediate phase in a polyol to form a second solution;
- reducing said intermediate phase in said second solution;
- allowing volatile reaction products to evolve from said second solution;
- spontaneous nucleating and growing metal nanoclusters (52) from said second solution.

**7.** Method according to claim 6 **characterized in that** said starting metal compound is chosen by the group comprising: metal hydroxides, metal oxides or metal salts.

**8.** Method according to any one of the claims 5-7 **characterized in that** said polyol is chosen between ethylene glycol (EG) and diethylene glycol (DEG).

**9.** Method according to claim 4 **characterized in that** the step of superficial passivation of said active metal with thiol comprises the following steps:

- suspending said metallic nanoclusters (52) in a third solution; and
- adding thiol compounds to said third solution in such a way that thiol molecules are chemically absorbed to the nanoclusters (52) surface.

**10.** Method according to claim 9 **characterized in that** said thiol compounds are dodecanthiol ($CH_3(CH_2)_{11}SH$) or a thiol excess having the formula: $CH_3(CH_2)_nSH$, where n is an integer.

**11.** Method according to claim 9 **characterized in that** said third solution comprises polyvinylpyrrolidone (PVP) as reducing agent and inhibitor of an aggregation process of the nanoclusters (52).

**12.** Method according to claim 4 **characterized in that** said step of extraction comprises an extraction of said metallic nanoclusters (52) using hydrocarbon (wet-way process).

**13.** Method according to claim 4 **characterized in that** said step of extraction comprises an addition of water followed by filtration (dry-way process).

**14.** Method according to claim 4 **characterized in that** said step of purification is conducted by dissolving said extracted metallic nanoclusters (52) in ethyl alcohol, adding acetone to precipitate said metallic nanoclusters (52), separating said metallic nanoclusters (52) by centrifugation and drying said metallic nanoclusters (52) to the air.

**15.** Method according to claim 4 **characterized in that** said step of forcing said metallic passivated nanoclusters (52) to assembly over said patterned substrate (10, 40) realizes at least one nanowire (70).

**16.** Method according to claim 15 **characterized in that** said step of realizing said at least one nanowire (70) comprises the following steps:

- realizing at least one nanocontact (56) in said patterned substrate (10, 40);

- using said nanocontact (56) as a target that offers a reference point for growing said nanowire (70) by moving said metallic passivated nanoclusters (52) under the control of said non homogeneous electric field.

**17.** Method according to claim 16 **characterized in that** said step of realizing said nanocontact (56) comprises the steps of:

- patterning said substrate (10, 40) in order to obtain a metallic layer (42) between two oxide layers (44, 46) with a free face (48) available for electro-deposition;

- applying said non homogeneous electric field between a plate electrode (50, 60) and said free face (48) in order to mode said metallic passivated nanoclusters (52) toward said free face (48);

- heating said metallic passivated nanoclusters (52) to remove said passivation and obtain said nanocontact (56) joining said free face (48).

**18.** Method according to claim 17 **characterized in that** said step of patterning said substrate (10, 40) further includes the realization of a plurality of electrodes (62, 64, 66, 68) surrounding a central aperture (14, 74).

**19.** Method according to claim 18 **characterized in that** said central aperture (14, 74) is rectangular and said electrodes (62, 64, 66, 68) are substantially central located with respect to the central aperture sides.

**20.** Method according to claim 18 **characterized in that** it further comprises a step of applying a potential difference is applied between four electrodes (62, 64, 66, 68), held to a same potential and a plate electrode (60) in order to oblige said metallic passivated nanoclusters (52) to migrate towards the free faces of said electrodes (62, 64, 66, 68) and to self-assembly in a direction perpendicular to those faces, so forming a plurality of nanowires (70).

**21.** Method according to claim 16 **characterized in that** said step of patterning said substrate (10, 40) further realizes an integrated microcavity (82).

**22.** Method according to claim 21 **characterized in that** said integrated microcavity (82) is realized by the following steps:

- forming a thin silicon oxide layer (12) on a silicon substrate (10);

- depositing metal contacts (72) on said silicon oxide layer (12), in such a way to form a central aperture (74) between said metal contacts (72);

- forming a sacrifical layer (76) in such a way to fill said central aperture (74) and to cover at least portions of said metal contacts (72);

- growing said thin silicon oxide layer (12) to form a thick silicon oxide layer (78) laterally of said sacrifical layer (76) and on said metal contacts (72);

- removing said sacrifical layer (76) so forming said integrated microcavity (82).

**23.** Method according to claim 22 **characterized in that** it further comprises a step of forming said plate electrode (60) on said thick silicon oxide layer (78) and above said central aperture (74), so closing said integrated microcavity (82).

**24.** Method according to claim 21 **characterized in that** said nanowires (70) are formed within said integrated microcavity (82).

**25.** Method according to claim 20 **characterized in that** said step of forming said nanowires (70) leaves a gap between the nanowires (70) defining a location for a quantum dot as single electron components.

**26.** Method according to claim 25 **characterized in that** said step of applying said non homogeneous electric field lets a nanocluster occupy said gap as a quantum dot.

**27.** Single electron device comprising a quantum dot as single electron component housed on a patterned substrate (10, 40) which includes at least an electrode (62, 64, 66, 68), **characterized in that** said electrode (62, 64, 66, 68) is connected by at least a nanowire (70) to said quantum dot.

**28.** Single electron device according to claim 27, **characterized in that** said quantum dot is realized by a metallic passivated nanocluster (52).

**29.** Single electron device according to claim 27, **characterized in that** it comprises a plurality of electrodes (62, 64, 66, 68) connected by a plurality of nanowires (70) to said quantum dot and **in that** said plurality of nanowires (70) have a gap defining a location for said quantum dot.

**30.** Single electron device according to claim 27, **characterized in that** said patterned substrate (10, 40) includes microcavity (82) having a central aperture (14, 74) surrounded by the electrodes (62, 64, 66, 68).

**31.** Single electron device according to claim 30, **characterized in that** said nanowires (70) and said quantum dot are housed in said microcavity (82).

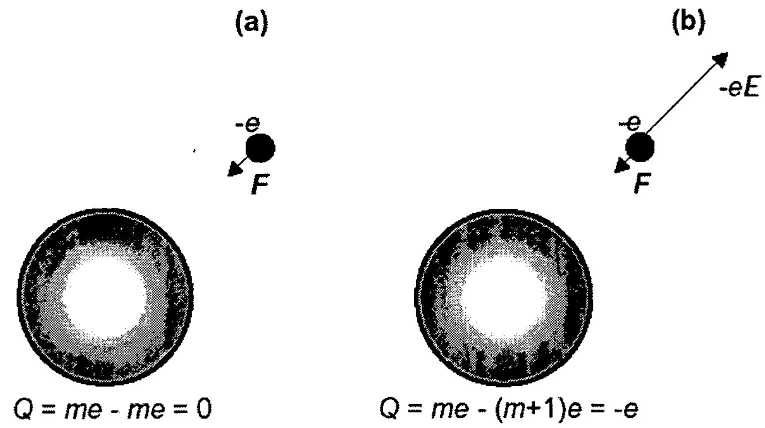
(a)
(b)
-e
F
-e
-eE
F
Q = me - me = 0
Q = me - (m+1)e = -e

# Fig. 1

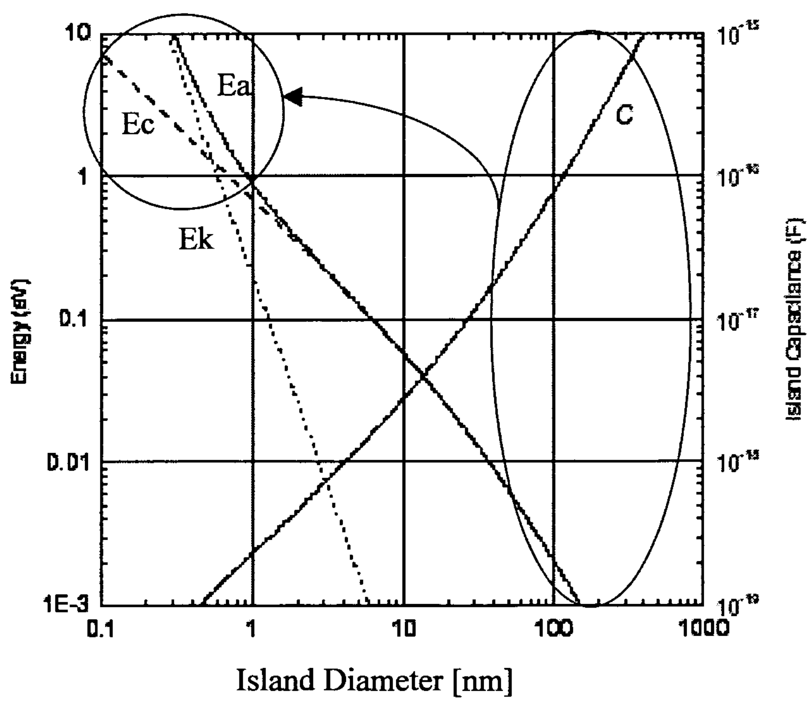
10
1
0.1
0.01
1E-3
Energy (eV)
Ea
Ec
Ek
C
0.1
1
10
100
1000
Island Diameter [nm]
Island Capacitance (F)

# Fig. 2

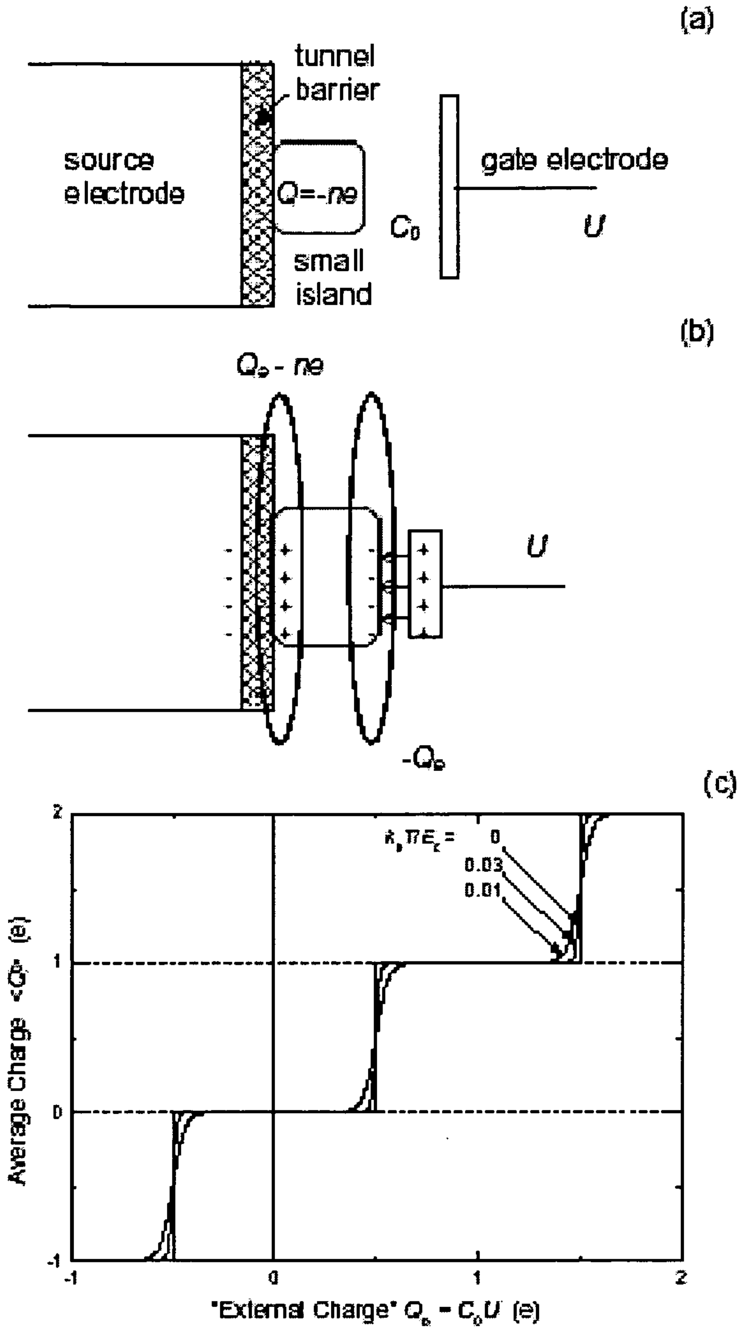
(a)
tunnel barrier
source electrode
Q=-ne
small island
C0
gate electrode
U
(b)
Qe - ne
U
-Qe
(c)
kBT/Ec = 0
0.03
0.01
Average Charge <Q> (e)
"External Charge" Qe = C0U (e)

Fig. 3

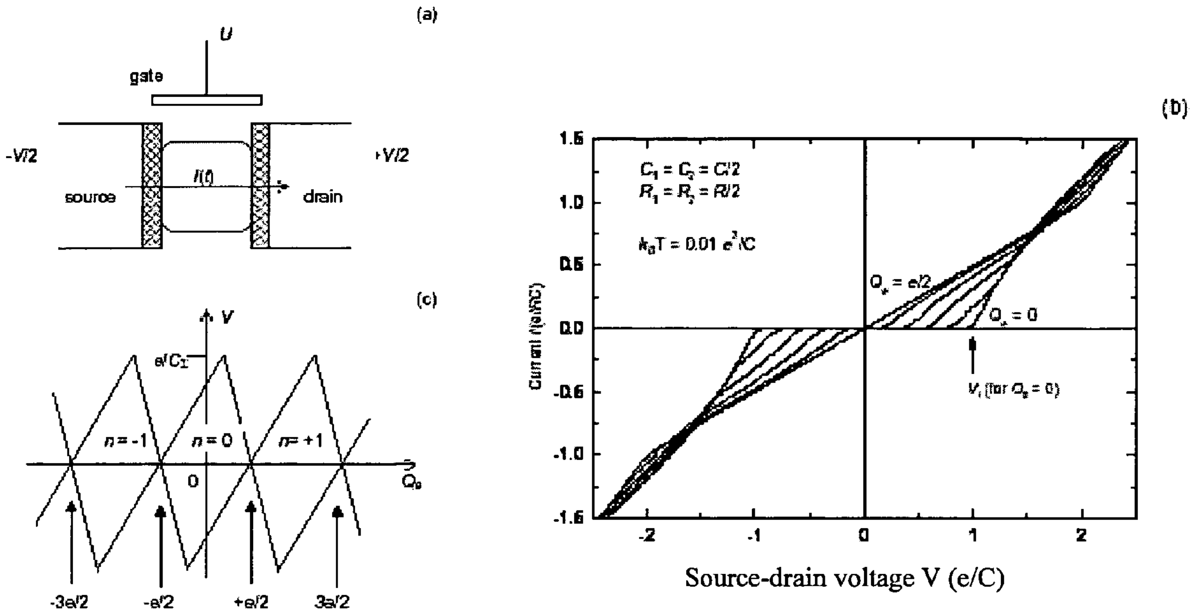


Fig. 4

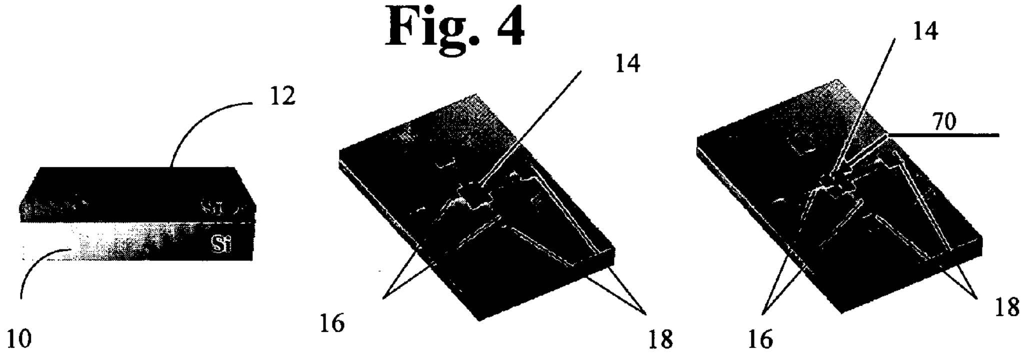


Figure 5a Figure 5b Figure 5c

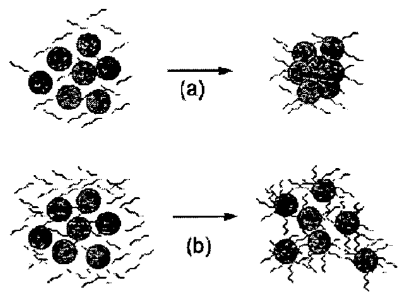


Fig. 6

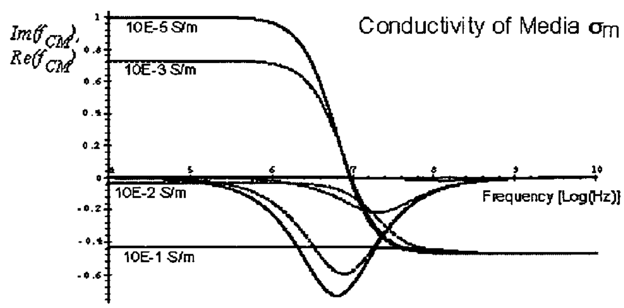


Fig. 7

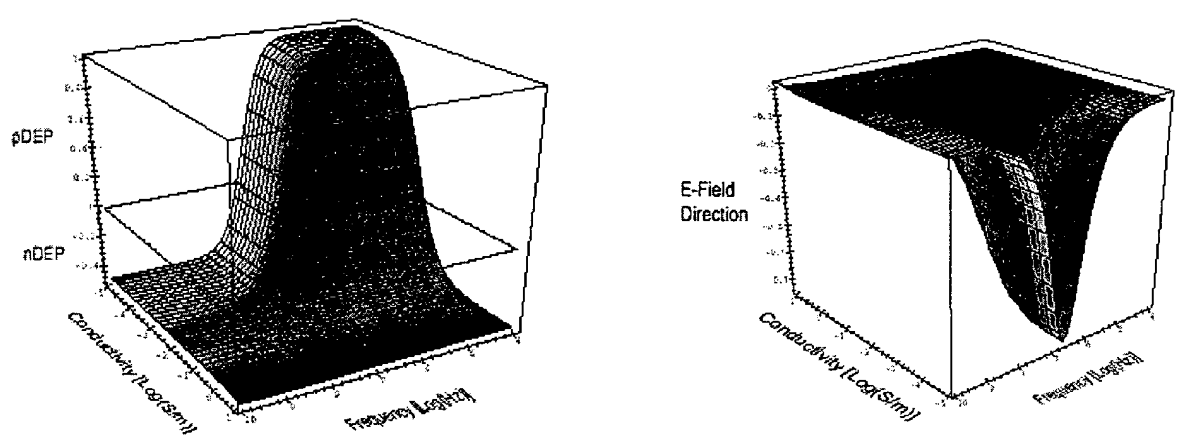


Fig. 8

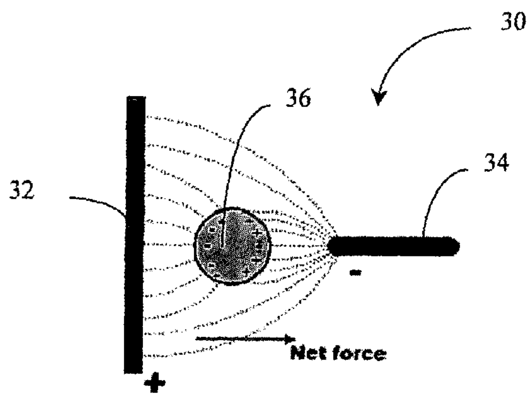


Fig. 9

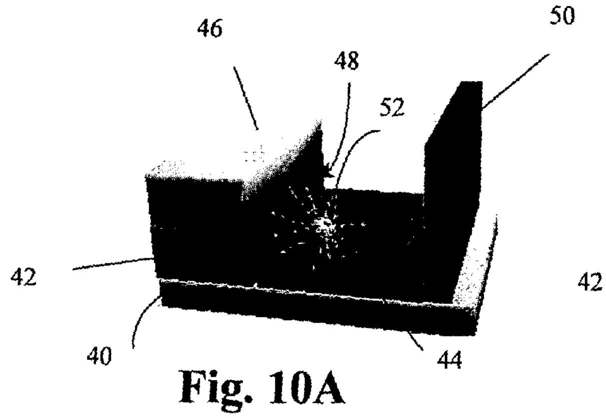


Fig. 10A

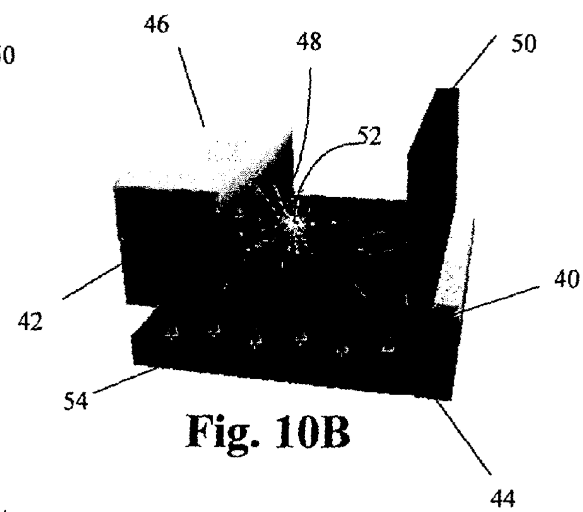


Fig. 10B

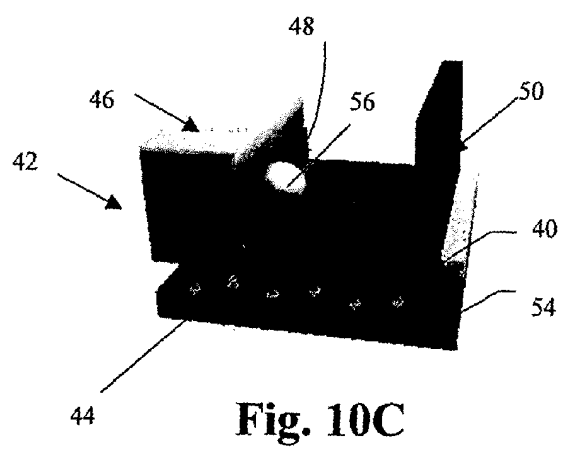


Fig. 10C

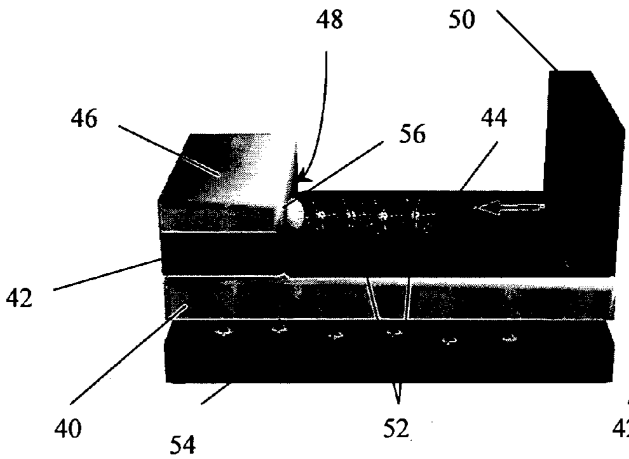


Fig. 11A

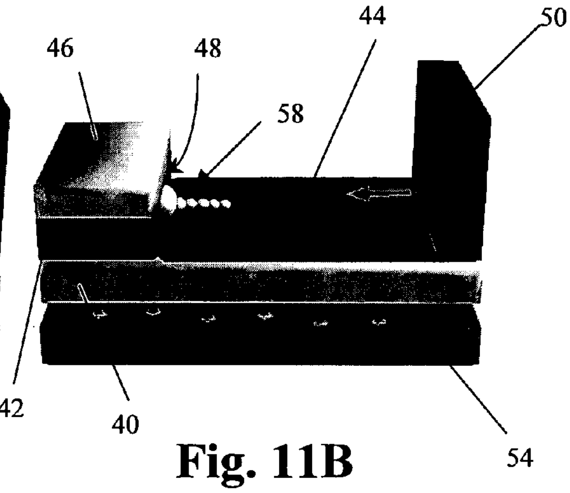


Fig. 11B

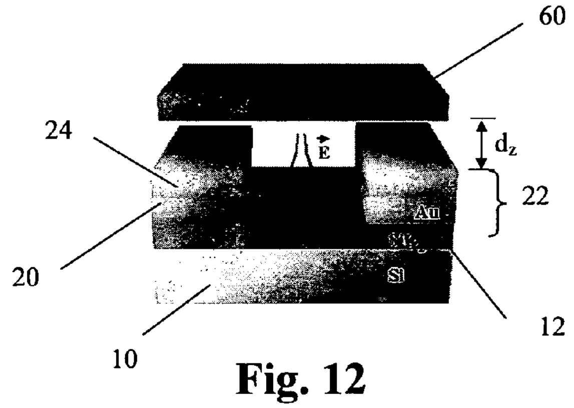


Fig. 12

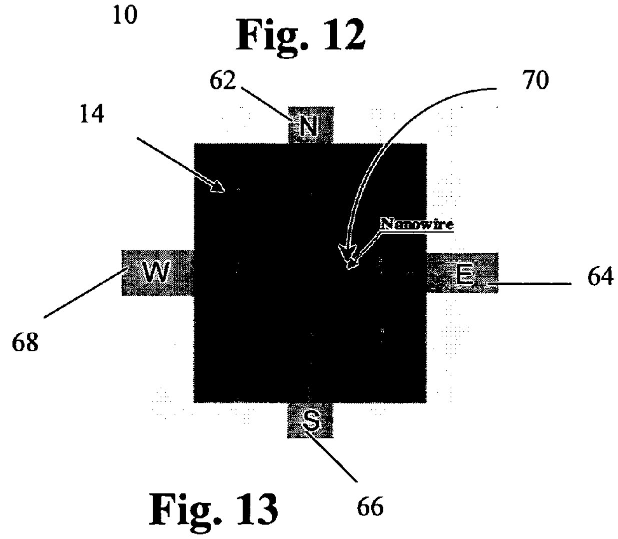


Fig. 13

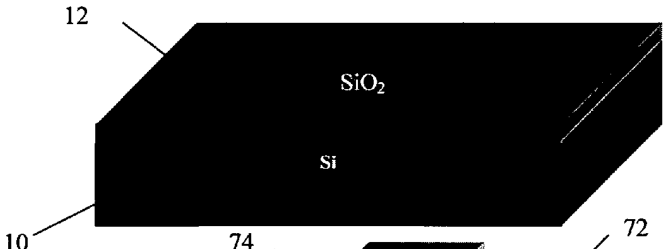


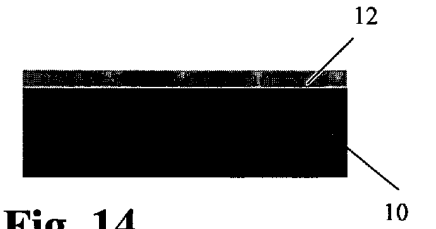


Fig. 14

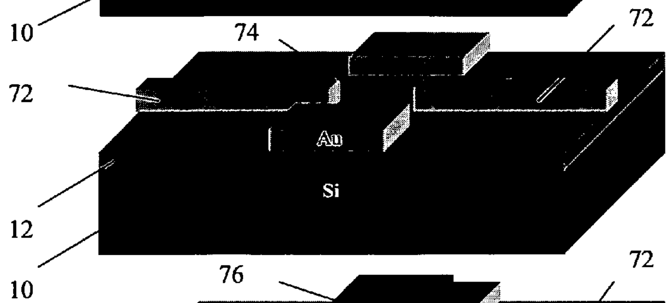


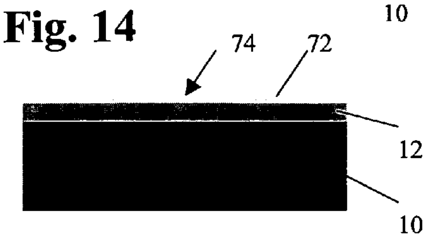


Fig. 15

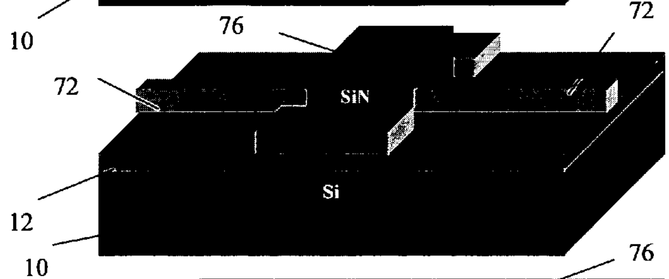


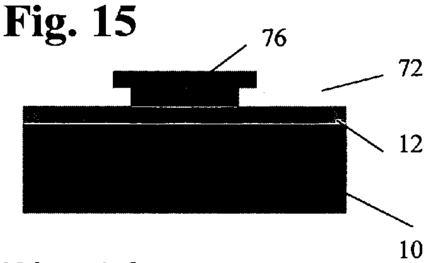


Fig. 16

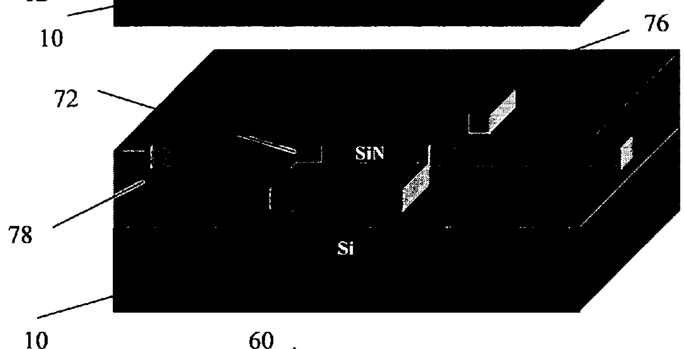


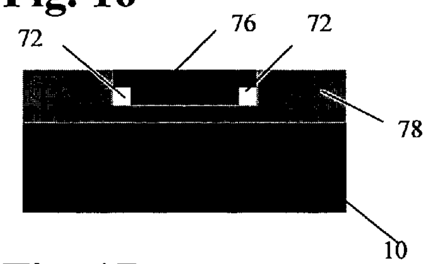


Fig. 17

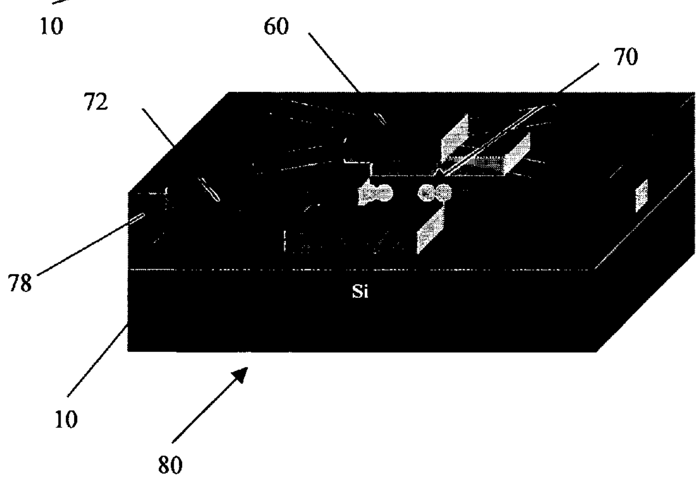


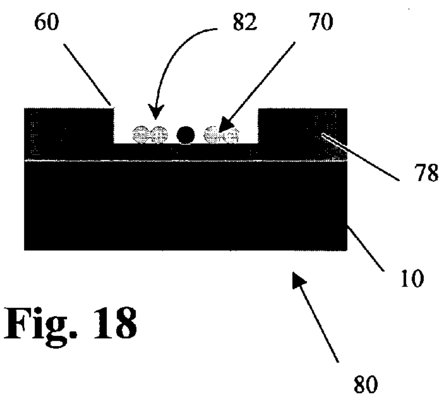


Fig. 18

European Patent Office

# EUROPEAN SEARCH REPORT

Application Number
EP 04 02 5635

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X<br><br>Y | US 2003/102444 A1 (DEPPERT KNUT WILFRIED ET AL) 5 June 2003 (2003-06-05)<br>* paragraphs [0066], [0067]; figures 1,3,5-7,10,11 * | 1,3, 27-29<br>2 | B82B3/00<br>B82B1/00<br>H01L49/00<br>H01L29/76 |
| A | WO 03/016209 A1 (CANTERPRISE LIMITED; BROWN, SIMON, ANTHONY; SCHMELZER, JUERN) 27 February 2003 (2003-02-27)<br>* page 5, line 25 - page 7, line 3; figures 14-16,19,26-28 * | 1-31 | |
| A | EP 0 865 078 A1 (HITACHI EUROPE LIMITED) 16 September 1998 (1998-09-16)<br>* column 6, line 51 - column 10, line 21; figures 2,3,5,6 * | 1-31 | |
| A | US 6 313 479 B1 (ZHANG ZHENYU ET AL) 6 November 2001 (2001-11-06)<br>* column 2, line 32 - column 3, line 12; figures 1-6 * | 1-31 | TECHNICAL FIELDS SEARCHED (Int.Cl.7) |
| Y | US 2003/048619 A1 (KALER ERIC W ET AL) 13 March 2003 (2003-03-13)<br>* abstract; figure 6 * | 2 | B82B<br>H01L |
| A | EP 0 836 232 A1 (SAMSUNG ELECTRONICS CO., LTD; GUBIN, SERGEI PAVLOVICH; KOLESOV, VLADIM) 15 April 1998 (1998-04-15)<br>* abstract; figures 1a,b * | 1-31 | |
| | -/-- | | |

The present search report has been drawn up for all claims

1

| Place of search | Date of completion of the search | Examiner |
|---|---|---|
| Munich | 1 February 2005 | Dauw, X |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

# EUROPEAN SEARCH REPORT

Application Number
EP 04 02 5635

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | HORI M ET AL: "Sub-5 nm gold dot formation using retarding-field single ion deposition" APPLIED PHYSICS LETTERS, AMERICAN INSTITUTE OF PHYSICS. NEW YORK, US, vol. 73, no. 22, 30 November 1998 (1998-11-30), pages 3223-3225, XP012021519 ISSN: 0003-6951 * the whole document * ----- | 1-31 | |

TECHNICAL FIELDS SEARCHED (Int.Cl.7)

The present search report has been drawn up for all claims

| Place of search | Date of completion of the search | Examiner |
|---|---|---|
| Munich | 1 February 2005 | Dauw, X |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

1

## ANNEX TO THE EUROPEAN SEARCH REPORT ON EUROPEAN PATENT APPLICATION NO. EP 04 02 5635

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2005

| Patent document cited in search report | Publication date | Patent family member(s) | Publication date |
|---|---|---|---|
| US 2003102444 A1 | 05-06-2003 | AU 5493301 A | 12-11-2001 |
| | | CA 2406006 A1 | 08-11-2001 |
| | | CN 1427962 T | 02-07-2003 |
| | | EP 1279068 A1 | 29-01-2003 |
| | | WO 0184238 A1 | 08-11-2001 |
| | | JP 2003531738 T | 28-10-2003 |
| WO 03016209 A1 | 27-02-2003 | NZ 513637 A | 27-02-2004 |
| | | CA 2458233 A1 | 27-02-2003 |
| | | EP 1425242 A1 | 09-06-2004 |
| EP 0865078 A1 | 16-09-1998 | JP 10321834 A | 04-12-1998 |
| | | US 5997958 A | 07-12-1999 |
| US 6313479 B1 | 06-11-2001 | US 2001034072 A1 | 25-10-2001 |
| US 2003048619 A1 | 13-03-2003 | NONE | |
| EP 0836232 A1 | 15-04-1998 | RU 2105386 C1 | 20-02-1998 |
| | | RU 2106041 C1 | 27-02-1998 |
| | | AU 2579297 A | 17-10-1997 |
| | | DE 69721929 D1 | 18-06-2003 |
| | | DE 69721929 T2 | 13-05-2004 |
| | | JP 11500583 T | 12-01-1999 |
| | | KR 272702 B1 | 15-11-2000 |
| | | US 6057556 A | 02-05-2000 |
| | | CN 1189921 A ,C | 05-08-1998 |
| | | WO 9736333 A1 | 02-10-1997 |

EPO FORM P0459

For more details about this annex : see Official Journal of the European Patent Office, No. 12/82